(19) Europäisches Patentamt
European Patent Office
Office européen des brevets

(11) **EP 4 474 352 A1**

(12) **EUROPEAN PATENT APPLICATION**
published in accordance with Art. 153(4) EPC

(43) Date of publication:
**11.12.2024 Bulletin 2024/50**

(21) Application number: **23747185.9**

(22) Date of filing: **31.01.2023**

(51) International Patent Classification (IPC):
**C01G 3/12** [(2006.01)]    **B82Y 20/00** [(2011.01)]
**B82Y 25/00** [(2011.01)]    **B82Y 30/00** [(2011.01)]
**B82Y 40/00** [(2011.01)]    **C01B 32/05** [(2017.01)]

(52) Cooperative Patent Classification (CPC):
**B82Y 20/00; B82Y 25/00; B82Y 30/00; B82Y 40/00;
C01B 32/05; C01G 3/12**

(86) International application number:
**PCT/JP2023/003128**

(87) International publication number:
**WO 2023/145975 (03.08.2023 Gazette 2023/31)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.01.2022  JP 2022013741**

(71) Applicant: **OSAKA UNIVERSITY
Suita-shi
Osaka 565-0871 (JP)**

(72) Inventor: **SAKAMOTO, Masanori
Suita-shi, Osaka 565-0871 (JP)**

(74) Representative: **Cabinet Beau de Loménie
158, rue de l'Université
75340 Paris Cedex 07 (FR)**

(54) **SEMICONDUCTOR NANOPARTICLE COMPOSITE FILM, COMPOSITE SUBSTRATE AND DEVICE CONTAINING SAID SEMICONDUCTOR NANOPARTICLE COMPOSITE FILM, AND METHOD FOR PRODUCING SEMICONDUCTOR NANOPARTICLE COMPOSITE FILM**

(57)  The present disclosure relates to a semiconductor nanoparticle composite film including semiconductor nanoparticles and diamond-like carbon (DLC), the composite film satisfying at least one selected from the group consisting of: i) the composite film includes mainly the semiconductor nanoparticles; and ii) at least a portion of the semiconductor nanoparticles are arranged in line.

The composite film can be obtained by, for example, irradiating a semiconductor nanoparticle-containing film including semiconductor nanoparticles and a carbon source with an ion beam to generate DLC. The carbon source includes an organic compound other than a polymer.

**EP 4 474 352 A1**

FIG.15

## Description

TECHNICAL FIELD

The present invention relates to a semiconductor nanoparticle composite film, and more specifically to a film in which semiconductor nanoparticles are composited with another material.

BACKGROUND ART

The present inventor has previously developed a conductive film including semiconductor nanoparticles (Patent Literature 1). The conductive film disclosed in Patent Literature 1 includes a binder together with the semiconductor nanoparticles. As in this conductive film, nanoparticles such as semiconductor nanoparticles are sometimes composited with another material in order to utilize the functions of the nanoparticles themselves in a composite film.

Nanoparticles are also used as a material to impart, to a film for utilizing the functions of another material, a different function. As a film with functions imparted by nanoparticles, a diamond-like carbon (hereinafter also referred to as "DLC") film having nanoparticles supported therein has been proposed (Patent Literature 2). In Patent Literature 2, a DLC film is formed by irradiating a macromolecular film with an ion beam. The macromolecular film used is a polymer film, such as a polyamide film or a polyvinylpyrrolidone film. According to Patent Literature 2, DLC films having nanoparticles supported therein retain excellent properties inherent in DLC, such as high hardness, electrical insulation, and infrared transmittance (paragraph 0019). The properties imparted to the DLC films by the supported nanoparticles are, for example, the antibacterial properties of Ag, the fluorescence of nanodiamond, the magnetism of Co, the catalytic properties of Pt, the photocatalytic properties of titanium oxide, and the cell affinity of hydroxyapatite (paragraph 0037).

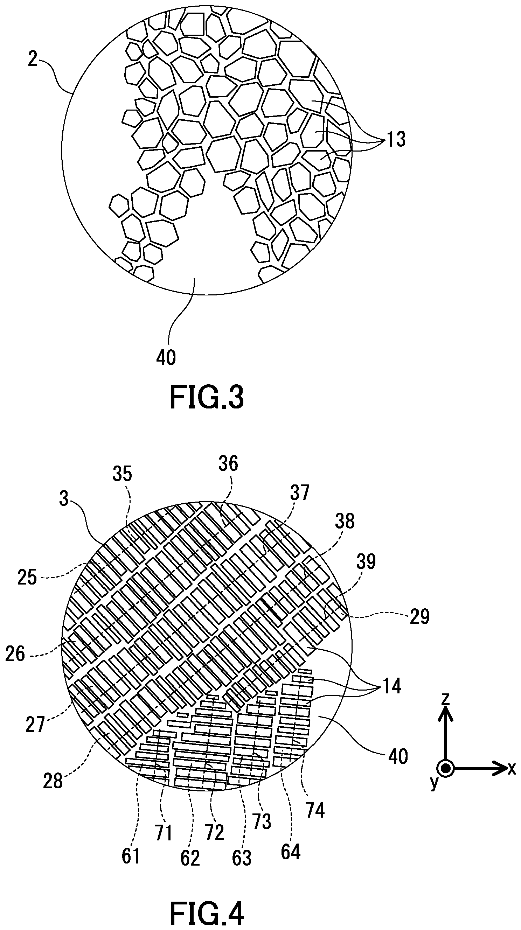

As can be understood from the above, the technique disclosed in Patent Literature 2 does not alter the properties inherent in DLC films, especially electrical insulation and infrared transmittance, through the addition of nanoparticles. In fact, in Patent Literature 2, nanoparticles are included in DLC films in a limited content so as not to impair the properties of the DLC films. For example, in the elemental mapping of a DLC film in which Ag nanoparticles are dispersed, the dots corresponding to the Ag nanoparticles occupy only an area significantly less than half of the cross-sectional area of the film (FIGS. 4 to 8).

CITATION LIST

Patent Literature

Patent Literature 1: WO 2021/75495
Patent Literature 2: WO 2014/175432

SUMMARY OF INVENTION

Technical Problem

The present invention aims to improve a film including semiconductor nanoparticles.

Solution to Problem

The present invention provides a semiconductor nanoparticle composite film including semiconductor nanoparticles and diamond-like carbon (DLC), the composite film satisfying at least one selected from the group consisting of:

  i) the composite film includes mainly the semiconductor nanoparticles; and
  ii) at least a portion of the semiconductor nanoparticles are arranged in line.

The present invention also provides a composite base including: a substrate; and the semiconductor nanoparticle composite film according to the present invention. The present invention further provides a device including: the semiconductor nanoparticle composite film according to the present invention; and a conductive portion electrically connected to the semiconductor nanoparticle composite film.

The present invention further provides, as a method for manufacturing the semiconductor nanoparticle composite film according to the present invention, a manufacturing method including:

forming a semiconductor nanoparticle-containing film including semiconductor nanoparticles and a carbon source; and

irradiating the semiconductor nanoparticle-containing film with an ion beam to generate DLC, thereby obtaining a semiconductor nanoparticle composite film including the semiconductor nanoparticles and the DLC, wherein the carbon source includes an organic compound other than a polymer.

Advantageous Effects of Invention

The present invention is suitable for improving a film including semiconductor nanoparticles.

BRIEF DESCRIPTION OF DRAWINGS

FIG. 1 is a cross-sectional view of an example of a composite film.
FIG. 2 is a view showing an example of the shape and the arrangement of semiconductor nanoparticles included in the composite film.
FIG. 3 is a view showing another example of the shape and the arrangement of the semiconductor nanoparticles included in the composite film.
FIG. 4 is a view showing yet another example of the shape and the arrangement of the semiconductor nanoparticles included in the composite film.
FIG. 5 is an example of an image obtained by transmission electron microscope (TEM) observation of the composite film.
FIG. 6 is another example of the image obtained by TEM observation of the composite film.
FIG. 7 is a schematic diagram for describing a flexural test on the composite film.
FIG. 8 shows an example of the measurement result of a relaxation time from localized surface plasmon excitation.
FIG. 9 shows an image (left) obtained by observing a composite particle composed of a semiconductor nanoparticle that is an infrared-absorbing particle and an acceptor bonded to the semiconductor nanoparticle, and a diagram (right) for describing separation of charges generated in the composite particle in response to infrared irradiation.
FIG. 10 is a cross-sectional view showing an example of a device including the composite film.
FIG. 11 is a cross-sectional view showing another example of the device including the composite film.
FIG. 12 is a diagram showing a cross section of yet another example of the device including the composite film together with a simplified view of the conductive portion.
FIG. 13 is a diagram for describing an example of release of charge carriers in the device shown in FIG. 12.
FIG. 14 is a diagram showing an example of X-ray diffraction results of composite films irradiated with an ion beam.
FIG. 15 is a diagram showing an example of the relationship between the ion beam irradiation duration and the surface resistivity of the composite films.
FIG. 16 is a diagram showing the results of the flexural test on the composite films.
FIG. 17 is an example of an image obtained by TEM observation of an example of a composite film including mainly semiconductor nanoparticles.
FIG. 18 is an example of an image obtained by TEM observation of an example of the composite film including mainly semiconductor nanoparticles.
FIG. 19 shows an example of spectral absorbance curves of composite films produced by using a nitrogen ion beam.
FIG. 20 shows an example of spectral absorbance curves of composite films produced by using a carbon ion beam.
FIG. 21 shows an example of spectral absorbance curves of composite films produced by using an argon ion beam.

DESCRIPTION OF EMBODIMENT

An embodiment of the present invention will be described below with reference to the drawings as appropriate. The following description is not intended to limit the present invention to any particular embodiment. The term "semiconductor" is used herein to include not only general semiconductors but also semimetals. Semimetals are materials having a band structure in which the bottom of the conduction band and the top of the valence band slightly overlap each other over the Fermi level due to a distortion of the crystal structure, an interaction between layers of crystals, or the like. The term "degenerate semiconductor" means a semiconductor having a band structure in which a conduction band or a valence band and the Fermi level overlap each other. The term "heavily doped semiconductor" is defined herein as a semiconductor having a free carrier density of $10^{18}/cm^3$ or more. The term "nanoparticles" means particles having a minimum particle diameter of less than 1 $\mu$m, for example, 0.1 nm or more and less than 1 $\mu$m. Nanoparticles typically mean particles having a maximum particle dimension of 5 $\mu$m or less, or even 3 nm to 2 $\mu$m. The "minimum diameter" of a particle is defined by the minimum dimension through the center of gravity of the particle, and the "maximum dimension" of a particle is defined by the longest line segment that can be set in the particle. Furthermore, the simple average of the "maximum dimension" is referred to as an "average maximum particle diameter". "Hydrophobic" is used as a term to refer to a surface property where the water contact angle is 60° or more, particularly 70° or more. In addition, the term "substantially parallel" is used to intend to limit the difference in direction to 10° or less, particularly 5° or less. The term "substantially perpendicular" is also used to intend to limit the difference in direction from a perpendicular direction to 10° or less, particularly 5° or less. The terms "autonomously arranged" and "autonomous arrangement" are used to mean that semiconductor nanoparticles are arranged in a self-organizing manner using the interaction between the particles as the driving force. Moreover, the term "functional group" is used as a term that includes halogen atoms.

As used herein, "including mainly semiconductor nanoparticles" means that the proportion of semiconductor nanoparticles is 50% or more on at least one selected from the group consisting of a mass basis, a volume basis, and an area basis. "Including mainly" on an area basis means occupying 50% or more of the cross-sectional area of a film. In addition, the upper and lower limits for the numerical ranges herein can be freely combined to constitute ranges.

The studies by the present inventor have found that it is possible to form a composite film including mainly semiconductor nanoparticles and including DLC. According to the studies by the present inventor, in particular, it has been found that ion beam irradiation generates DLC from a low molecular weight compound attached to semiconductor nanoparticles. In other words, a polymer film is not essential as the raw material for DLC. Additional blending of a polymer decreases the proportion of semiconductor nanoparticles in a film. Incorporation of a polymer between semiconductor nanoparticles causes disorder in the particle arrangement. By using the method discovered by the present inventor, it is possible to generate DLC even in small spaces near semiconductor nanoparticles close to each other.

Surprisingly, it has been found that DLC can contribute to an improvement in the film properties, such as conductivity, exhibited by the involvement of a plurality of semiconductor nanoparticles. Although the details of the mechanism have not been elucidated at this stage, the improvement in the film rigidity attributed to DLC has possibly affected the conductive paths extending throughout the film via a plurality of semiconductor nanoparticles. The enhancement effect attributed to DLC can be exhibited prominently in a film having a high proportion of semiconductor nanoparticles to the extent that the film includes mainly the semiconductor nanoparticles and in a film where at least a portion of semiconductor nanoparticles are arranged in line. While the above description uses conductivity as an example, incorporation of DLC into a semiconductor nanoparticle composite film can also contribute to an improvement in the film properties besides conductivity, needless to say. For example, DLC can function as an acceptor that accepts charge carriers generated by irradiating semiconductor nanoparticles with light such as an infrared ray, thereby contributing to an improvement in the heat blocking property of the film. In addition, for example, DLC can contribute to an improvement in the folding resistance of the film. In one preferred example of the present embodiment, at least a portion of DLC is generated from a low molecular weight compound other than a polymer, but not all of the DLC does not need to be derived from the low molecular weight compound.

<Semiconductor Nanoparticle Composite Film>

The semiconductor nanoparticle composite film of the present embodiment (hereinafter also simply referred to as a "composite film") is a composite film including semiconductor nanoparticles and another material. The other material includes at least DLC. The composite film of the present embodiment satisfies the following i) and/or ii): i) the composite film includes mainly the semiconductor nanoparticles; and ii) at least a portion of the semiconductor nanoparticles are arranged in line.

The composite film may include the semiconductor nanoparticles so that the above i) will be satisfied. As described above, "including mainly" is satisfied when the semiconductor nanoparticles account for 50% or more on at least one selected from a mass basis, a volume basis, and an area basis. The determination on an area basis can be performed relatively simply by observing the film cross section with an electron microscope. In this case, the film cross section is preferably a cross section substantially perpendicular to the planar direction of the composite film. Specifically, this determination is performed on five randomly selected cross sections. In the case where any of the selected cross sections is inconclusive as to whether to be regarded as "including mainly", five additional cross sections are measured and the determination is performed based on the proportion of the total area of the semiconductor nanoparticles in the total area of the ten cross sections in total. The area of each of the film cross sections to be observed should be set to 2000 $nm^2$ or more, and if possible, 10000 $nm^2$ or more.

The composite film may include the semiconductor nanoparticles so that the above ii) will be satisfied. In this case, the composite film includes an arrangement portion of the semiconductor nanoparticles. In the arrangement portion, the semiconductor nanoparticles are arranged in line. When a cross section including the arrangement portion is observed, the semiconductor nanoparticles may be arranged apart from each other in the arrangement portion. The composite film may include a plurality of arrangement portions extending substantially parallel to each other. The composite film may include a plurality of arrangement portions intersecting each other or connecting to each other at their end portions.

In the cross section where the arrangement portion of the semiconductor nanoparticles is observed, the average spacing between adjacent semiconductor nanoparticles is preferably 10 nm or less. The "average spacing" between semiconductor nanoparticles is determined by measuring the shortest distance between each two adjacent particles apart from each other in the arrangement portion of the semiconductor nanoparticles appearing in the film cross section, and calculating the arithmetic average of them. In one example, the average distance can be determined by measuring the shortest distance between two adjacent particles apart from each other at 10 points along a portion where the two particles face each other, and calculating the arithmetic average of them (so-called ten-point average). In the arrangement portion in the above cross section, the semiconductor nanoparticles that are adjacent to each other are preferably apart from each other such that opposite sides of the adjacent semiconductor nanoparticles are substantially parallel to each other. The arrangement portion may be formed by an autonomous arrangement of the semiconductor nanoparticles in the film formation.

The composite film may include a compound adhering to the semiconductor nanoparticles, that is, an adhered compound. The adhered compound is a compound different from a semiconductor constituting the semiconductor nanoparticles, typically an organic or inorganic compound that is not a semiconductor. The adhered compound may be a compound that is not a macromolecule. The adhered compound may be a compound that is not a polymer. The adhered compound may be a compound different from an adhered material for protecting semiconductor nanoparticles in an ink for composite film formation against aggregation. The molecular weight of the adhered compound is preferably 300 or less, 200 or less, 150 or less, more preferably less than 110, and particularly preferably less than 60. The adhered compound may have a functional group suitable for bonding with the semiconductor nanoparticles, for example, a ligand that can be bonded to a metal atom by a coordinate bond.

However, using such an adhered compound is not essential. A composite film free of an adhered compound can also exhibit sufficient properties for practical use, depending on the type of semiconductor nanoparticles, properties required for composite films, and other factors. Moreover, even in the case where an adhered compound is included before ion beam irradiation, the adhered compound is partly lost from the film due to its transformation to DLC or other factors after the ion beam irradiation, decreasing in the content in the film or being removed from the film.

The composite film may be free of a macromolecule. The composite film may be free of a polymer. In the case where the composite film is a multilayer film, the composite film may be free of a macromolecule and/or a polymer in its layer including the semiconductor nanoparticles. In this case, however, the multilayer film may include, for example, a polymer in another layer.

The three-dimensional shape of the semiconductor nanoparticles may be a columnar body and/or a polyhedron. The bottom surface of the columnar body is not limited to any particular shape and is, for example, a circle, an ellipse, or a polygon. The columnar body is typically a column having identical and parallel bottom surfaces. However, the columnar body is not limited to this and is, for example, a three-dimensional body whose longitudinal section cut along a plane passing through both bottom surfaces is a quadrilateral or can be regarded as a quadrilateral. The polyhedron may be a regular polyhedron, such as a regular hexahedron, but is not limited to this. One preferred three-dimensional shape is a disc-shaped columnar body, in which when the bottom surface is regarded as a circle having the same area, the height is 1/2 times or less, even 1/3 times or less, particularly 1/4 times or less the diameter of the circle (hereinafter, such a shape is simply referred to as "disc-shaped" or "disc shape"). However, the columnar body is not limited to this and may be a rod-shaped columnar body, in which when the bottom surface is regarded as a circle having the same area, the height is two times or more, even three times or more, particularly four times or more the diameter of the circle (hereinafter, such a shape is simply referred to as "rod-shaped" or "rod shape"). The three-dimensional shape of the semiconductor nanoparticles may be a rod shape and/or a disc shape.

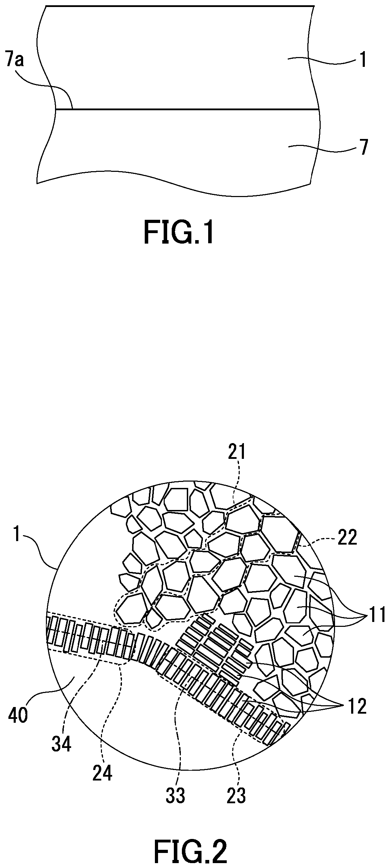

FIG. 1 shows an example of the composite film. A composite film 1 is formed on a surface 7a of a base 7. FIG. 1 shows a film cross section of the composite film 1 cut along a direction perpendicular to the surface 7a. FIG. 2 shows semiconductor nanoparticles 11 and 12 included in the composite film 1. The aspect of the shape and the arrangement of the semiconductor nanoparticles 11 and 12 as shown in FIG. 2 can be observed with, for example, a TEM. The minimum diameter of the semiconductor nanoparticles 11 and 12 is less than 1 $\mu$m, for example, 500 nm or less, and preferably 100 nm or less. In the present embodiment, in a matrix 40 where the semiconductor nanoparticles 11 and 12 are not present, at least DLC is included.

In the film cross section of the composite film 1 shown in FIG. 2, the semiconductor nanoparticles 11 and 12 appear. The semiconductor nanoparticles 11 in the film cross section are each substantially a polygon having five or more vertices, specifically a pentagon or a hexagon. The semiconductor nanoparticles 12 in the film cross section are each substantially a quadrilateral. The semiconductor nanoparticles 12 in the film cross section are each more specifically a rectangle, even more specifically a rectangle in which the long side corresponding to the bottom surface is twice or more the short side corresponding to the height. The semiconductor nanoparticles 11 and 12 thus observed are each, for example, disc-shaped. However, the shape of the semiconductor nanoparticles in the film cross section is not limited to the above and may be, for example, a circle, an ellipse, a triangle, or a quadrilateral other than a rectangle, such as a square.

In the case where the semiconductor nanoparticles 12 appearing in the film cross section are each a rectangle, the length of the long side of the rectangle is, for example, 3 to 2000 nm, even 5 to 900 nm, or even 20 to 50 nm. The length of the short side of the semiconductor nanoparticles 12 is, for example, 2 to 100 nm or even 3 to 20 nm. The ratio in length of the long side to the short side of the semiconductor nanoparticles 12 may be, for example, 2 or more.

The composite film 1 includes arrangement portions 21 and 22 in which the semiconductor nanoparticles 11 are arranged and arrangement portions 23 and 24 in which the semiconductor nanoparticles 12 are arranged. In the arrangement portions 21 to 24, the semiconductor nanoparticles are arranged in line out of contact with adjacent nanoparticles. In the arrangement portions 21 and 22, the semiconductor nanoparticles 11 that are substantially pentagonal or hexagonal are arranged. In the arrangement portions 23 and 24, the semiconductor nanoparticles 12 that are substantially rectangular are arranged. The number of semiconductor nanoparticles arranged in each of the arrangement portions is not particularly limited. The number of arranged semiconductor particles may be 3 or more, 7 or more, and in some cases 10 or more, or even 20 or more.

In the arrangement portions 21 to 24, a straight line passing through the semiconductor nanoparticles included in each of the arrangement portions can be drawn. In other words, each of the arrangement portions is arranged in line along an arrangement direction that is a straight line. Note that in FIG. 2, only arrangement directions 33 and 34 of the respective arrangement portions 23 and 24 are shown, and the other arrangement directions are omitted. Note that in the film cross section in FIG. 2, in addition to the arrangement portions of the semiconductor nanoparticles shown, arrangement portions of the semiconductor nanoparticles appear that are omitted for simplicity.

In the arrangement portions 23 and 24, the adjacent semiconductor nanoparticles 12 are apart from each other such that opposite sides thereof are substantially parallel to each other. In such arrangement portions, the average spacing between the adjacent semiconductor nanoparticles 12 can be easily held small. An arrangement including semiconductor nanoparticles with small spacings therebetween is advantageous in achieving high conductivity. Furthermore, in the arrangement portions 23 and 24, the opposite sides of the adjacent semiconductor nanoparticles 12 are the long sides of rectangles. In such an arrangement structure in which the opposite sides are relatively long, even when the arrangement of the semiconductor nanoparticles 12 has a partial disorder, a portion where the semiconductor nanoparticles 12 are close to each other can be easily held, and accordingly, the arrangement can be easily maintained over a long distance. This feature is also advantageous in achieving high conductivity.

The average spacing between the semiconductor nanoparticles is, for example, 10 nm or less, even 7 nm or less, and in some cases 5 nm or less, 3 nm or less, even 2 nm or less, and particularly preferably 1.8 nm or less. The average spacing may be, for example, 0.3 nm or more or even 0.5 nm or more.

FIGS. 3 and 4 each show a cross section of another example of the composite film. In a film cross section of a composite film 2, only semiconductor nanoparticles 13 appear that are substantially pentagonal or hexagonal. The semiconductor nanoparticles appearing in a film cross section of a composite film 3 are only semiconductor nanoparticles 14 that are rectangular. In FIG. 4, the semiconductor nanoparticles 14 that are rectangular are arranged in arrangement portions 25, 26, 27, 28, and 29 respectively extending along arrangement directions 35, 36, 37, 38, and 39 that are substantially parallel to each other. Furthermore, the semiconductor nanoparticles 14 that are substantially rectangular are also arranged in arrangement portions 61, 62, 63, and 64 respectively extending along arrangement directions 71, 72, 73, and 74 that are not substantially parallel to the arrangement directions 35 to 39, respectively, and are substantially parallel to each other. In the film cross section in FIG. 4, a large number of arrangement portions are present in which substantially rectangular semiconductor nanoparticles are arranged. In these arrangement portions, the semiconductor nanoparticles 14 are arranged, over a long distance, in line adjacent to and apart from each other such that opposite sides of the semiconductor nanoparticles are substantially parallel to each other. Such a film cross section is advantageous in sufficiently increasing the conductivity in the in-plane direction.

It should be noted that even in the composite film 2, which has a film cross section (FIG. 3) where the arrangement portion in which the rectangular semiconductor nanoparticles are arranged is not observed, the arrangement portion in which the rectangular semiconductor nanoparticles are arranged can be observed in a different film cross section, for example, in a direction perpendicular to the drawing plane in FIG. 3. For example, assume a film where the three-dimensional shape of the semiconductor nanoparticles 13 is a disc shape and the nanoparticles adjacent in the height direction are arranged apart from each other such that the bottom surfaces thereof face each other. This film can have a film cross section as shown in FIG. 4 depending on the cutting direction.

FIGS. 2 to 4 show the aspect in which all the semiconductor nanoparticles 11 to 14 are apart from each other. However, the semiconductor nanoparticles may be partly in contact with each other in different portions. It should also be noted that even when semiconductor nanoparticles are actually apart from each other, the semiconductor nanoparticles can be observed to be in contact with each other or overlap each other depending on the direction of observation, the resolution of the equipment used for observation, and the like.

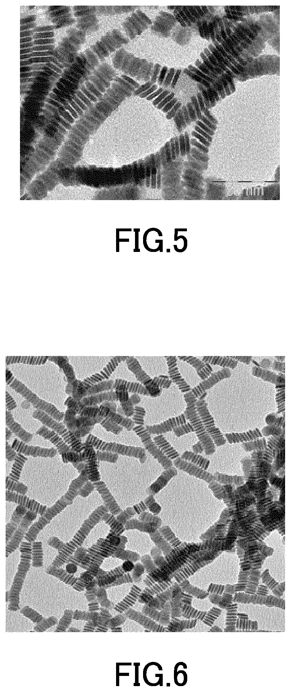

The arrangement state of the semiconductor nanoparticles in a region larger than those in FIGS. 2 to 4 is illustrated in FIGS. 5 and 6. As shown in these figures, the arrangement portions of the semiconductor nanoparticles do not need to extend in the same direction. Paths each constituted from a plurality of arrangement portions may be curved, flexed, intersect each other, or partly overlap each other. The paths, which are each constituted from the plurality of arrangement portions, form a conductive path.

The composite films 1 to 3 include the matrix 40 in which the semiconductor nanoparticles 11 to 14 are not present. The matrix 40 includes DLC, and in some cases a binder such as an adhered compound. In the case where DLC is generated by ion beam irradiation, the binder should include a carbon source before ion beam irradiation. The carbon source is a source of carbon atoms constituting the DLC. Although the binder becomes transformed or decomposed due to ion beam irradiation, the binder may remain in the film after ion beam irradiation. The binder may be an organic compound (e.g., a monomer or oligomer) other than a polymer or may be an inorganic compound free of a carbon atom. However, in the case where DLC is generated by ion beam irradiation, the binder is preferably an organic compound other than a polymer. The material such as DLC or the binder may be interposed between the semiconductor nanoparticles adjacent to each other in the arrangement portion. DLC may also be formed to connect different arrangement portions to each other.

The matrix 40 may constitute an element permitting an autonomous arrangement of the semiconductor nanoparticles 11 to 14. An appropriate arrangement of the semiconductor nanoparticles 11 to 14 may cause anisotropy in the conductivity of the composite films 1 to 3. The matrix 40 can also be an element contributing to an improvement in the light transmittance of the composite films 1 to 3. The matrix 40 can also be an element suppressing a decrease in the conductivity of the composite films 1 to 3 due to bending. In a cross section where an arrangement portion in which semiconductor nanoparticles are arranged is observed, the matrix 40 in which semiconductor nanoparticles are not present may account for 10% or more, 20% or more, 30% or more, or even 40% or more of the entirety in terms of area proportion. In this case, it is possible to sufficiently suppress a decrease in conductivity due to bending. Moreover, the matrix 40 may account for less than 50%, 40% or less, 30% or less, or even 20% or less of the entirety in terms of area proportion. In this case, it is possible to sufficiently ensure conductivity through the semiconductor nanoparticles. These upper and lower limits can constitute a numerical range by freely selected combinations as described above, and the area proportion of the matrix is, for example, 10% or more and less than 50%. However, in a film including mainly semiconductor nanoparticles on a basis other than an area basis, the area proportion of the matrix may be 50% or more, for example, 50% or more and 90% or less.

The composite films 1 to 3 preferably include, in at least the manufacturing process, a compound adhering to the semiconductor nanoparticles 11 to 14. This compound can be interposed between the semiconductor nanoparticles adjacent to each other in the arrangement portion, thereby contributing toward keeping the spacing between the semiconductor nanoparticles narrow. The compound preferably has a low molecular weight. The compound adhering to the semiconductor nanoparticles tends to disappear by ion beam irradiation. Even in the case where the compound remains after the irradiation, subsequent heating, for example, can remove the compound from the film or decrease the content of the compound in the film. Especially a compound having a low molecular weight, such as hydrazine, tends to disappear from the composite film over time by so-called volatilization without intentional heating.

The composite film has a conductivity C1 of 7 S/cm or more or even 10 S/cm or more, preferably 20 S/cm or more, more preferably 50 S/cm or more, even more preferably 100 S/cm or more, particularly preferably 150 S/cm or more, and in some cases 200 S/cm or more, particularly 500 S/cm or more, or even 1000 S/cm or more. The conductivity C1 is only required to be obtained by measurement along at least one direction. This direction may be the film surface direction parallel to the surface of the film, or may be the film thickness direction perpendicular to the surface of the film. In practice, high conductivity of a composite film is often required for a specific direction. For example, in an extremely thin composite film, the length in the film surface direction is much larger than the film thickness. Accordingly, an improvement in the conductivity in the film surface direction substantially solves practical problems in many cases. In the composite film of the present embodiment, the conductivity converted from the surface resistivity may be in the range described as C1.

As can be understood from the above, the conductivity of the composite films 1 to 3 may have anisotropy resulting from the arrangement state of the semiconductor nanoparticles. The composite film according to the present embodiment may be a film in which the conductivity C1 is measured along a first direction and a conductivity C2 lower than the conductivity C1 is measured along a second direction. In the case where the first direction is the film surface direction, the second direction may be the film thickness direction. In the case where the first direction is the film thickness direction, the second direction may be the film surface direction.

The conductivity C2 may be, for example, less than 80%, less than 50%, or even less than 1% of the conductivity C1. Note that by appropriately arranging the semiconductor nanoparticles, it is possible to improve not only the conductivity C1 but also the conductivity C2. The conductivity C2 is, for example, $1 \times 10^{-3}$ S/cm or more, and in some cases may be $1 \times 10^{-1}$ S/cm or more, even 1 S/cm or more, particularly 100 S/cm or more. Note that the composite film of the present embodiment does not necessarily require anisotropy in conductivity.

Although disorder in the arrangement of the semiconductor nanoparticles is an obstacle to achievement of the conductivity as high as above, the presence of DLC can suppress a decrease in conductivity.

The directional dependence of the conductivity of the composite film is affected at least by the affinity of the semiconductor nanoparticles for the surface of the base and by the three-dimensional shape of the semiconductor nanoparticles. For example, semiconductor nanoparticles whose three-dimensional shape is disc-shaped are arranged on the surface of a base having a low affinity for semiconductor nanoparticles, such that the disc surface is substantially perpendicular to the surface of the base. These semiconductor nanoparticles are arranged on the surface of a base having a high affinity for semiconductor nanoparticles, such that the disc surface is substantially parallel to the surface of the base. Furthermore, for example, semiconductor nanoparticles whose three-dimensional shape is a rod-shape are arranged on the surface of a base having a low affinity for semiconductor nanoparticles, such that the axial direction (long axis direction) of the rod is substantially perpendicular to the surface of the base, in other words, such that the rod stands on the surface. These semiconductor nanoparticles are arranged on the surface of a base having a high affinity for semiconductor nanoparticles, such that the axial direction of the rod is substantially parallel to the surface of the base, in other words, such that the rod lies on the surface.

To control the directional dependence of the conductivity of the composite film through the arrangement of the semiconductor nanoparticles, the base to be used should be selected appropriately or the affinity of the surface of the base should be adjusted. For example, to arrange rod-shaped semiconductor nanoparticles on the surface of a base having a low affinity for semiconductor nanoparticles such that the long axis direction of the rod is substantially parallel to the surface, a material having a high affinity for semiconductor nanoparticles should be applied to the surface of the base in advance. This arrangement is suitable for formation of a composite film having a relatively high conductivity C1 in the film thickness direction.

It is possible to obtain the enhancement effect attributed to DLC without the presence of the arrangement portion of the semiconductor nanoparticles in the film. Even in a film including mainly semiconductor nanoparticles, DLC can imparting adequate rigidity to the film to improve functions such as conductivity exhibited by the semiconductor nanoparticles. In particular, in a dense portion where semiconductor nanoparticles are densely present and are at least partly in contact with each other, the enhancement effect attributed to DLC tends to be exhibited prominently as in the arrangement portion. In contrast, in a film having a limited proportion of semiconductor nanoparticles and being irregularly dotted with the semiconductor nanoparticles apart from each other, electrical insulation and infrared transmittance, which are properties inherent in DLC, tend to predominate.

The light transmittance of the composite film at a wavelength of 650 nm is, for example, 30% or more, 40% or more, 50% or more, 60% or more, 70% or more, 80% or more, even 85% or more, preferably 90% or more, and more preferably 92% or more. Note that a composite film having a high light transmittance of 80% or more is also called a transparent conductive film. Furthermore, the light transmittance of the composite film at the same wavelength may be 40% or more or even 50% or more, and a light transmittance of 30% or more is sometimes sufficient depending on the application. The upper limit for the light transmittance of the composite film at the same wavelength is not particularly limited and is, for example, 95% or less, and in some cases 80% or less. Furthermore, the light transmittance of the composite film for the visible light region (region at the wavelength of 400 to 800 nm) may be, for example, 40% or more or even 50% or more over the entire composite film.

Similarly, the light transmittance of the composite film at a wavelength of 560 nm is, for example, 30% or more, 40% or more, 50% or more, 60% or more, 70% or more, 80% or more, even 85% or more, preferably 90% or more, and more preferably 92% or more. Furthermore, the light transmittance of the composite film at the same wavelength may be 40% or more or even 50% or more, and a light transmittance of 30% or more is sometimes sufficient depending on the application. The upper limit for the light transmittance of the composite film at the same wavelength is not particularly limited and is, for example, 95% or less, and in some cases 80% or less.

The film thickness of the composite film is not particularly limited and is only required to be appropriately set depending on the application. The film thickness is, for example, 5 to 5000 nm, 5 to 2000 nm, even 10 to 1000 nm, particularly 100 to 800 nm.

The composite film may have a surface resistivity of 10000 $\Omega/\square$ or less, 5000 $\Omega/\square$ or less, 1000 $\Omega/\square$ or less, 300 $\Omega/\square$ or less, 200 $\Omega/\square$ or less, or 100 $\Omega/\square$ or less. The lower limit for the surface resistivity is not particularly limited and is, for example, 10 $\Omega/\square$ or more.

While the above description uses conductivity and the like as examples of the properties that the composite film can have, it is not essential for the composite film to have, for example, conductivity as high as above. The composite film can have a function depending on the properties of the semiconductor nanoparticles.

The composite film of the present embodiment can have particularly excellent folding resistance owing to the combination of the semiconductor nanoparticles and DLC. The composite film including semiconductor nanoparticles and a binder and free of DLC, that is, a composite film before incorporation of DLC, has a rate of change in resistance increasing through about 2000-time flexing in a flexural test, and the rate sometimes exceeds 70%, for example. In contrast, the composite film of the present embodiment can have a rate of change in resistance of 50% or less, 30% or less, or even 20% or less even through 2000-time flexing in a flexural test. According to the present embodiment, it is also possible to suppress the rate of change in resistance of the composite film to 50% or less, 30% or less, or even 20% or less even through 5000-time or even 10000-time flexing in a flexural test.

The rate of change in resistance can be calculated by the following formula:

$$(R2 - R1)/R1) \times 100$$

where R1 is the surface resistivity ($\Omega/\square$) before a flexural test in which flexing is applied a predetermined number of times, and R2 is the surface resistivity ($\Omega/\square$) after the flexural test.

The flexural test is performed on a 20 mm × 5 mm rectangular test piece having a composite film formed thereon. The test piece is curved along the 20-mm side with the composite film positioned on the inner side, and is placed between a pair of members at a distance of 5 mm. In this state, the test is started. The pair of members are moved toward each other until the distance therebetween is 2.5 mm, and then moved away from each other until the distance is 5 mm. This one cycle is counted as one-time flexing, and flexing is performed five times per second. Flexing is applied a predetermined number of times in the test, followed by measurement of the surface resistivity. The surface resistivity can be measured by a four-point probe method. In the measurement by a four-point probe method, the center of the sample should be targeted. In the case where measurement at the center of the sample is difficult for example, measurement may be performed at several positions (e.g., four positions) including a position close to the center so that the average will be calculated.

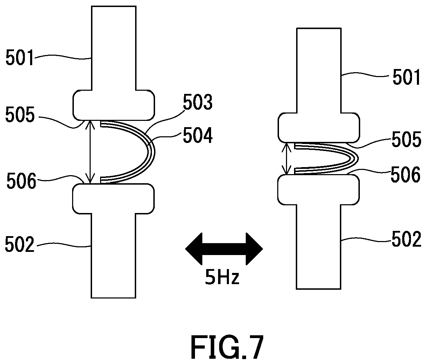

FIG. 7 is a reference diagram for a flexural test. In a tester, a pair of members 501 and 502 respectively have flat surfaces 505 and 506 parallel to each other, and are repeatedly moved toward and away from each other as shown in the figure with the surfaces 505 and 506 maintained in a parallel state. The distance between the surfaces 505 and 506 is represented by the arrows. A base 503 on which a composite film 504 is formed can be, for example, a polyethylene terephthalate (PET) substrate. The members 501 and 502 are rigid stainless steel members, for example.

The composite film of the present embodiment can have excellent weather resistance. For example, in a composite film including silver nanowires as conductive elements, oxidation or migration progresses, resulting in a rapid decrease in conductivity in an environment of high temperature and humidity, unless the composite film is coated with an overcoat. In the composite film of the present embodiment including DLC, which is chemically stable and has a structure close to a diamond structure in addition to the semiconductor nanoparticles as conductive elements, in contrast, the functions such as conductivity are less prone to be affected even in the state where the surface of the film is exposed to an atmosphere of high temperature and humidity.

<Components of Composite Film>

(Semiconductor Nanoparticles)

The semiconductor nanoparticles may include, as the semiconductor material, a compound semiconductor, specifically at least one selected from an oxide, a sulfide, a selenide, and a telluride. Examples of preferred oxides include tin oxide, indium oxide, zinc oxide, tungsten oxide, molybdenum oxide, cadmium oxide, copper oxide, vanadium oxide, and copper gallium oxide. Examples of preferred sulfides include copper sulfide and copper indium sulfide. Examples of preferred selenides include copper selenide. Examples of preferred tellurides include copper telluride. The semiconductor nanoparticles may include a semiconductor material other than titanium oxide.

Titanium oxide is an n-type semiconductor material.

The semiconductor nanoparticles may include a p-type semiconductor material. A p-type semiconductor material, such as copper sulfide, is more suitable than an n-type semiconductor material for incorporation into a film subjected to modification involving irradiation with a positive ion beam, that is, an ion beam having positive charges. Irradiation with a positive ion beam, such as a helium ion, nitrogen ion, carbon ion, or argon ion beam, can be performed more simply than irradiation with a negative ion beam. The p-type semiconductor material may be generated from a semiconductor material other than a p-type semiconductor material, for example, an intrinsic semiconductor, by ion beam irradiation. However, the semiconductor nanoparticles may include an intrinsic semiconductor, an n-type semiconductor material, or the like, without being limited to a p-type semiconductor material. Even under the assumption that an n-type semiconductor material is irradiated with a positive ion beam, the properties of the composite film such as folding resistance can be improved.

However, the ion beam for irradiating the semiconductor nanoparticles may be a negative ion beam, that is, an ion beam having negative charges. The semiconductor nanoparticles in the film irradiated with a negative ion beam may include an n-type semiconductor material. This n-type semiconductor material may be generated from a semiconductor material other than an n-type semiconductor material, for example, an intrinsic semiconductor, by ion beam irradiation, or may be an impurity semiconductor material as described below. For example, tin-doped indium oxide (ITO) is both an n-type semiconductor material and an impurity semiconductor material.

The semiconductor nanoparticles may include an impurity semiconductor material to which a minor component, particularly a component for improving the conductivity, called a dopant, is added. The impurity semiconductor is, for example, tin-doped indium oxide (ITO), aluminum-doped indium oxide, cerium-doped indium oxide, aluminum-doped zinc oxide, gallium-doped zinc oxide, indium-doped zinc oxide, indium-doped cadmium oxide, fluorine-indium-doped cadmium oxide, fluorine-doped cadmium oxide, chlorine-doped cadmium oxide, bromine-doped cadmium oxide, cesium-doped molybdenum oxide, cesium-doped tungsten oxide, antimony-doped tin oxide (ATO), fluorine-doped tin oxide (FTO). The impurity semiconductor may include a dopant, a defect, or the like to such an extent that the impurity semiconductor is considered to be a degenerate semiconductor, a heavily doped semiconductor, or the like.

The semiconductor nanoparticles may include a semiconductor material suitable for infrared absorption. The semiconductor material suitable for infrared absorption is, for example, a semiconductor material that can absorb an infrared ray by localized surface plasmon resonance (hereinafter also referred to as an "LSPR-IR absorbing semiconductor"). A composite film including the above semiconductor is suitable for applications focused on infrared absorption, such as heat blocking purposes. The presence of LSPR in the LSPR-IR absorbing semiconductor can be confirmed by, for example, a method for revealing that a change in absorption peak wavelength is linear, the change being obtained by changing the refractive index of an ambient medium.

The LSPR-IR absorbing semiconductor may be a material whose relaxation time from localized surface plasmon excitation can be 1 ns or longer. The material having such a property is, for example, at least one selected from the group consisting of copper sulfide, copper selenide, and cesium tungsten oxide (CWO). However, the material having such a property is not limited to these materials, and an appropriate material may be selected by measuring the relaxation time from localized surface plasmon excitation by time-resolved transient absorption spectroscopy.

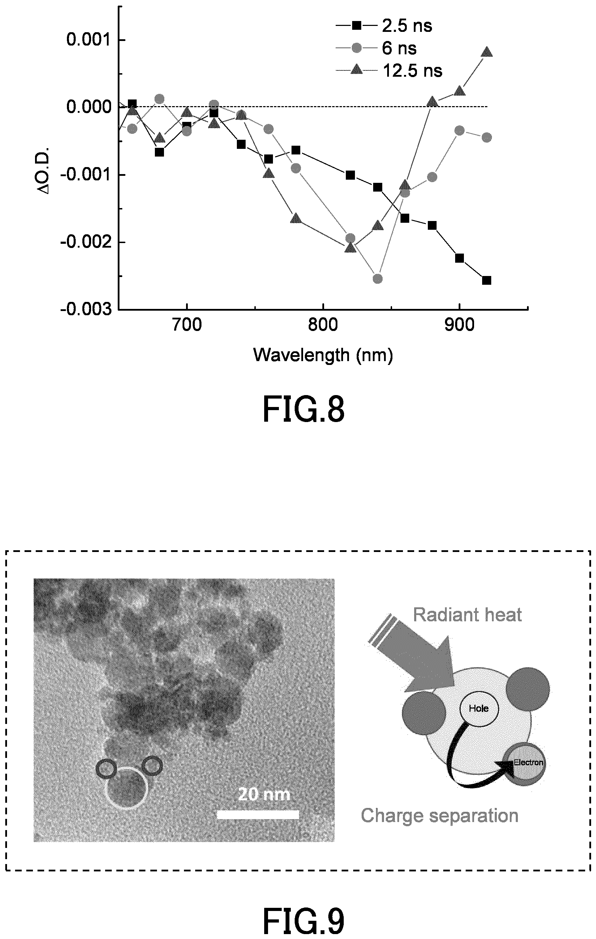

FIG. 8 shows an example of the result of measurement of the relaxation time from localized surface plasmon excitation by time-resolved transient absorption spectroscopy. FIG. 8 shows an absorption spectrum obtained 2.5 nanoseconds (ns), 6 ns, and 12.5 ns after the localized surface plasmon excitation. In the absorption spectrum shown in FIG. 8, bleach (negative signal) by the localized surface plasmon excitation is observed in a near-infrared region. In the example shown in FIG. 8, the negative signal still remains 2.5 ns, 6 ns, and even 12.5 ns later, indicating a relaxation time of at least 10 ns or longer. A material that can exhibit such a long relaxation time of active carriers after excitation of LSPR regardless of the wavelength and intensity of pump light is suitable as the LSPR-IR absorbing semiconductor. Note that the time-resolved transient absorption spectroscopy should be a direct method of directly measuring the entire duration of a phenomenon.

FIG. 8 shows the measurement result for copper sulfide. This measurement was performed by a pump-probe method using a chloroform solution of copper sulfide as a specimen, a picosecond laser with a wavelength of 1064 nm as pump light, and a supercontinuum light source as probe light. The laser light and the probe light are specifically as follows.

- Picosecond laser ("PL2210A" manufactured by EKSPLA; repetition frequency: 1 kHz; pulse width: 25 ps; pulse energy: 0.9 mJ (wavelength: 1064 nm))
- Supercontinuum light source ("SC450" manufactured by Fianium Ltd.; repetition frequency: 20 MHz; pulse width: 50 to 100 ps)

However, these conditions are an example, and appropriate conditions for measurement of the relaxation time from localized surface plasmon excitation can be set depending on the material to be measured.

In the case where the composite film is used for infrared absorption, DLC can function as a so-called acceptor. The composite film may further include an acceptor other than DLC. The acceptor other than DLC may be included as particles, particularly as nanoparticles. Note that an acceptor is a material that accepts electrons or holes, generated in semiconductor nanoparticles by infrared irradiation, from the semiconductor nanoparticles. The acceptor other than DLC may be of any type that can accept electrons or holes from the semiconductor nanoparticles. An acceptor material included in the acceptor is appropriately selected depending on the semiconductor material included in the semiconductor nanoparticle, preferably an LSPR-IR absorbing semiconductor. In the case where the LSPR-IR absorbing semiconductor is copper sulfide, the acceptor may include cadmium sulfide. In the case where the LSPR-IR absorbing semiconductor is tungsten oxide doped with cesium, the acceptor may include, for example, at least one selected from zinc oxide, titanium oxide, tin oxide, and gallium oxide. In the case where the LSPR-IR absorbing semiconductor is ITO, the acceptor may include tin oxide. The acceptor may be included as particles, or may be included so as to form a layer. The acceptor may be included in the same layer including the semiconductor nanoparticles, or may be included in a layer adjacent to the layer including the semiconductor nanoparticles. Furthermore, the acceptor may be a conductive organic material, such as graphene, carbon nanotube, or graphite.

The semiconductor nanoparticle and the acceptor may form a composite particle by being bonded to and integrated with each other. FIG. 9 shows an example of the composite particle. This composite particle is a composite particle obtained by allowing tin oxide ($SnO_2$) particles to adhere to an ITO particle. The tin oxide particles may be bonded to the ITO particle physically or chemically. As shown in the right-side diagram in FIG. 9, as for a hole and an electron generated by an infrared ray ("radiant heat" in the diagram), the electron moves to one of the $SnO_2$ particles that are an acceptor and is separated from the hole that remains in the ITO particle.

EP 4 474 352 A1

As can be understood from the above, the acceptor itself may be nanoparticles of a semiconductor material. In the case where the composite film includes an acceptor being nanoparticles of a semiconductor material, the proportion of the semiconductor nanoparticles in the composite film is calculated inclusive of the acceptor as a portion of the semiconductor nanoparticles.

As described above, in the present embodiment, iii) the semiconductor nanoparticles may include a p-type semiconductor material; iv) the semiconductor nanoparticles may include an impurity semiconductor material; v) the semiconductor nanoparticles may include an LSPR-IR absorbing semiconductor; and vi) the composite film may further include a material that accepts electrons or holes, generated in the semiconductor nanoparticles by infrared irradiation, from the semiconductor nanoparticles. In the present embodiment, at least one selected from the group consisting of iii) to vi) may be satisfied.

Satisfaction of the above iii) to vi) is undoubtedly useful in the case where the above i) and/or ii) are satisfied, and is also useful in the case where neither the above i) nor ii) is satisfied.

In other words, the present invention provides, in another aspect, a semiconductor nanoparticle composite film including semiconductor nanoparticles and DLC, the composite film satisfying at least one selected from the group consisting of:

iii) the semiconductor nanoparticles include a p-type semiconductor material;
iv) the semiconductor nanoparticles include an impurity semiconductor material;
v) the semiconductor nanoparticles include an LSPR-IR absorbing semiconductor; and
vi) the composite film further includes an acceptor material that accepts electrons or holes, generated in the semiconductor nanoparticles by infrared irradiation, from the semiconductor nanoparticles.

This composite film is a semiconductor nanoparticle composite film including semiconductor nanoparticles and DLC, and the semiconductor nanoparticles include at least one semiconductor material selected from the group consisting of: a p-type semiconductor material; an impurity semiconductor material; an LSPR-IR absorbing semiconductor material; and an acceptor material that is other than the DLC and accepts electrons or holes, generated in the semiconductor nanoparticles by infrared irradiation, from the semiconductor nanoparticles.

As described above, in the present embodiment, DLC can function as an acceptor for charge carriers. In other words, in the composite film, electrons or holes, generated in the semiconductor nanoparticles by infrared irradiation, at least partly move to the DLC. This movement is suitable for releasing charge carriers from the composite film. In this case, the semiconductor nanoparticles and the DLC should be appropriately selected according to each other's properties (HOMO level, LUMO level, etc.).

Movement of the charge carriers to the DLC is undoubtedly useful in the case where the above i) and/or ii) are satisfied, and is also useful in a device including a film in which neither the above i) nor ii) is satisfied, particularly in a heat blocking device.

In other words, the present invention provides, in another aspect,

a heat blocking device that blocks at least a portion of an infrared ray with which the heat blocking device is irradiated, the heat blocking device including
a composite film including: semiconductor nanoparticles that absorb the infrared ray to generate electrons and holes; and an acceptor that is DLC and accepts the electrons or the holes from the nanoparticles, wherein
at least a portion of charge carriers selected from the electrons and the holes are released from the composite film to an outside of the heat blocking device.

The average maximum particle diameter of the semiconductor nanoparticles is not particularly limited and is, for example, 1 nm to 2000 nm, even 3 nm to 1000 nm, preferably 5 nm or more, 10 nm or more, 18 nm or more, 20 nm or more, or even 25 nm or more. In particular, relatively large semiconductor nanoparticles having an average maximum particle diameter of 20 nm to 2000 nm contribute greatly to an improvement in the conductivity of the composite film. This effect is obtained prominently for a composite film formed on a resin substrate, such as a PET substrate. The improvement in conductivity owing to the size increase in the semiconductor nanoparticles is presumably related to the hydrophobic property of the surfaces of resin substrates. For a particle with a shape where the particle diameter is difficult to determine, the above range is applied by interpreting the average maximum particle diameter as the maximum dimension.

Semiconductor nanoparticles that are relatively large to the above extent are suitable for further strengthening the property enhancement effect attributed to DLC, and are undoubtedly useful in the case where the above i) and/or ii) are satisfied, and are also useful in the case where neither the above i) nor ii) is satisfied.

In other words, the present invention provides, in another aspect,

a semiconductor nanoparticle composite film including semiconductor nanoparticles and DLC, wherein

the semiconductor nanoparticles have an average maximum particle diameter of 20 nm to 2000 nm.

A composite film including semiconductor nanoparticles having an average maximum particle diameter within the above range is preferably formed on a hydrophobic surface, for example, on a substrate with a hydrophobic surface. Specifically, the composite film including semiconductor nanoparticles having an average maximum particle diameter within the above range is preferably formed on a resin substrate to constitute a composite base.

The semiconductor nanoparticles may be crystalline or amorphous. However, in the case where the nanoparticles include crystals, the crystal structure thereof might affect the conductivity of the semiconductor nanoparticles. In addition, the type of crystal can affect even the three-dimensional shape of the semiconductor nanoparticles. Although a preferred crystal structure differs depending on the type of semiconductor nanoparticles, for example, copper sulfide preferably includes at least one selected from the group consisting of covellite, anilite, roxybite, digenite, and djuleite, and particularly preferably includes covellite and/or roxybite. The nanoparticles including copper sulfide may include only at least one crystal selected from the above. The semiconducting nanoparticles may also include a 2D material, and specifically may be nanoparticles including a carbide and/or a nitride of a 2D material having a semiconductivity and oriented in the plane direction. Examples of the 2D material include M2CT2 (M is at least one selected from the group consisting of Sc, Y, and Lu; T is at least one selected from the group consisting O, F, and OH) and M2CO2 (M is at least one selected from the group consisting of Hf, Zr, and Ti). The 2D material may be so-called MXene.

The semiconductor nanoparticles preferably have a three-dimensional shape that results in a locally ordered structure by an autonomous arrangement. This three-dimensional shape is specifically a shape having a cross section where substantially parallel opposite sides appear, and is typically a columnar body and/or a polyhedron. An example of the three-dimensional shape is a columnar body whose bottom surface is a circle, an ellipse, a polygon, or a shape that can be approximated to any one of these. This shape may be the rod shape or the disc shape described above.

(DLC)

Diamond-like carbon (DLC) is an amorphous film with a skeletal structure of carbon atoms bonded in both $SP^3$ bonds and $SP^2$ bonds. DLC is known as a material having properties such as high abrasion resistance and low friction. For this reason, DLC is usually formed as a coating consisting of itself, that is, a film. Known methods for DLC film formation include deposition by vapor-phase synthesis, such as plasma CVD, as well as irradiation of a polymer film with an ion beam to transform a polymer into DLC.

As described above, incorporation of DLC into the semiconductor nanoparticle composite film satisfying the above i) and/or ii) is performed suitably by a method in which an organic compound other than a polymer is used as a carbon source. For example, the semiconductor nanoparticle composite film can be formed by performing ion beam irradiation on a semiconductor nanoparticle-containing film in which semiconductor nanoparticles are included and an organic compound other than a polymer is included as the binder for the semiconductor nanoparticles. The binder may consist of an organic compound other than a polymer.

The presence of DLC can be confirmed by measuring both $SP^3$ bonds and $SP^2$ bonds as the bonds between carbon atoms. Specifically, in Raman spectra, when both bonds exhibit peaks at specified wavenumbers, namely, near 1330 $cm^{-1}$ for $SP^3$ bonds and near 1550 $cm^{-1}$ for $SP^2$ bonds, the presence of DLC can be confirmed. The presence of DLC can be confirmed not only by Raman spectroscopy but also by, for example, electron energy loss spectroscopy (EELS), X-ray diffractometry (XRD), or infrared spectroscopy (IR).

(Binder)

The composite film may include a binder together with the semiconductor nanoparticles and DLC. Although DLC is also a binder component in terms of being interposed between the semiconductor nanoparticles to form a film, the binder is treated here as a component other than DLC. The binder is a preferred component that, together with DLC, can impart flexibility to the composite film by being interposed between the semiconductor nanoparticles. The binder can also contribute to an improvement in the film formability of the semiconductor nanoparticle-containing film to be irradiated with an ion beam, an appropriate arrangement of nanoparticles, and the like.

The binder may include an adhered compound adhering to the semiconductor nanoparticles. The adhered compound may include a functional group that can be bonded to the semiconductor nanoparticles, for example, at least one selected from the group consisting of fluoride (F), chloride (Cl), bromide (Br), iodide (I), cyanide (CN), thiocyanate (SCN), isothiocyanate (NCS), hydroxide (OH), mercapto (SH), carbonyl (CO), amino ($NR_3$), nitrosyl (NO), nitrito ($NO_2$), phosphane ($PR_3$), carbene ($R_2C$), and pyridine ($NC_5H_5$). Here, each R is independently an organic residue or a hydrogen atom. As can be understood from the above examples, the functional group that can be bonded to the semiconductor nanoparticles may be another functional group that can function as a ligand to a metal atom or an anion.

The adhered compound may be an inorganic compound or an organic compound. In addition, the adhered compound may be a salt formed of an ion including any of the functional groups exemplified above or consisting of the functional group and a counter ion thereof. The adhered compound may be a compound having a plurality of the functional groups described above, typified by hydrazine ($H_2NNH_2$), ethylenediamine ($H_2NCH_2CH_2NH_2$), ethylenedithiol ($HSCH_2CH_2SH$), mercaptopropionic acid ($HSCH_2CH_2COOH$), acetylacetonate ($H_3CCOCHCOCH_3$), aminobenzonitrile ($NH_2C_6H_4CN$), and the like.

The molecular weight of the adhered compound is, for example, 300 or less, preferably 200 or less, more preferably 100 or less, even more preferably 80 or less, and in some cases less than 60. The lower limit for the molecular weight is not particularly limited and is, for example, 20 or more or even 30 or more. The use of an adhered compound having a molecular weight that is not excessively high is suitable for controlling the spacing between the semiconductor nanoparticles to be narrow.

The content of the adhered compound in the composite film is only required to be appropriately adjusted depending on the type thereof. The content may be, for example, 1% or more, even 2% or more, particularly 3% or more, and in some cases 5% or more, and preferably 8% or more, as expressed by the proportion of the mass of the adhered compound to the sum amount of the semiconductor nanoparticles and the adhered compound. The upper limit for the content is not particularly limited and is 30% or less or even 20% or less.

The binder may include a material other than the adhered compound, for example, various resins. Examples of such resins include polyvinyl alcohol, polyvinyl acetal, polyvinyl pyrrolidone, carboxymethyl cellulose, acrylic resin, polyvinyl acetate, polyethylene terephthalate, polystyrene, and polyethylene. However, these macromolecular materials may be included in, for example, a layer different from the layer including the semiconductor nanoparticles, such as a coating layer or underlying layer for the layer including the semiconductor nanoparticles. The binder may include, for example, a pH adjuster, a colorant, a thickener, or a surfactant depending on the necessity in film formation of the composite film, the application, and the like.

<Composite Base>

The composite base of the present embodiment includes: a substrate; and the composite film including the semiconductor nanoparticles and the DLC. The substrate is not limited to any particular material and is only required to be made of a material suitable for the application, such as a resin, glass, fiber, or metal. The substrate may be made of a flexible material, such as a woven fabric, a non-woven fabric, paper, or a film. A transparent substrate may be used depending on the application. The composite base may use the composite film as at least one functional film selected from an electrode film, an antistatic film, a heat generating film, a heat blocking film, a light shielding film, an antenna, a heater, a spectral filter, an abrasion-resistant film, a chemical-resistant film, a refraction-resistant film, a coloring film, a photocatalytic film, a catalytic film, an optical refractive film, a water-repellent film, a hydrophilic film, a slippery film, an adhesion-resistant film, a biocompatible film, a gas barrier film, a corrosion-resistant film, a low-aggressive film, and an electromagnetic shielding film.

The substrate may also include a material that can constitute a portion of the composite film, for example, an organic compound such as a resin. For example, a portion of a substrate made of a resin may be transformed into DLC by ion beam irradiation so as to constitute a portion of the composite film. In this case, at least a portion of the carbon source of the DLC can include a polymer. Even in the above case, the carbon source included in the semiconductor nanoparticle-containing film may be an organic compound other than a polymer.

<Device>

The composite film of the present embodiment can be used in various devices, for example, devices including light-transmissive films. Examples of such devices include photovoltaic devices typified by solar cells, image display devices typified by liquid crystal displays and organic EL displays, heat generating devices typified by heated windshields, and electromagnetic shielding devices typified by electromagnetic shielding windows and heat shielding windows. The device is, for example, at least one selected from the group consisting of a photovoltaic device, an image display device, a heat generating device, and an electromagnetic shielding device. In these devices, the composite film is used as an electrode film, an antistatic film, a heat generating film, an electromagnetic shielding film, or the like. By using the composite film having high transparency for the above-described applications, advantages can be obtained such as no interference with product design, no interference with information communication, and achievement in invisibility.

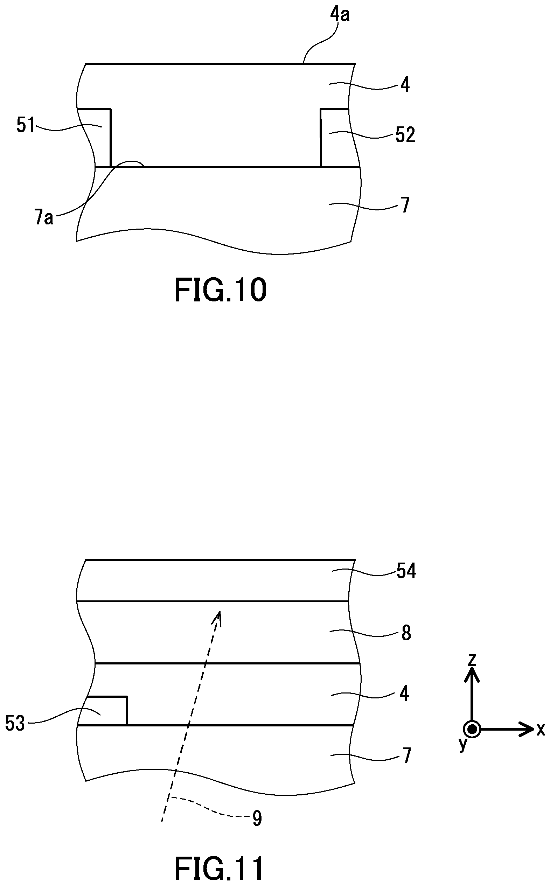

In the devices described above, at least one electrode is sometimes arranged in contact with the composite film for energization or discharge of electric charges. FIGS. 10 and 11 show examples of electrode arrangement. In the example shown in FIG. 10, a pair of electrodes 51 and 52 are arranged apart from each other in the film surface direction of a composite film 4. By applying a potential difference to the electrodes 51 and 52, an electric current flows in the film surface direction of the composite film 4. This composite film can function, for example, as a heat generating film. The electrodes 51 and 52 do not need to be formed on the surface 7a of the base 7, and may be formed on the surface 4a of the composite film 4. To discharge electric charges from the composite film not for heat generation but for charge prevention or the like, only one electrode is necessary.

In the example shown in FIG. 11, the composite film 4 in contact with an electrode 53 is used as a light-transmissive electrode. For example, when light 9 transmitted through the composite film 4 enters a functional film 8, a potential difference is generated between the electrode 53 and an electrode 54 due to the photoelectric conversion function of the functional film 8. Furthermore, in another device, when a potential difference is applied between the composite film 4 and the electrode 54, a voltage is applied to the functional film 8 along its film thickness direction (z direction in FIG. 11). This causes the functional film 8 to emit light traveling toward a direction opposite to a direction in which the incident light 9 travels. In the example in FIG. 11, the base 7 can be a transparent substrate, such as a glass substrate or a transparent resin substrate, and the electrode 54 can be a metal film, such as an aluminum film. However, the base 7 and the electrode 54 are not limited to these examples. For example, the base 7 may be a substrate having a thin film on its surface.

In the aspect shown in FIG. 11, the electrode 53 extends along a direction perpendicular to the drawing plane (y direction in FIG. 11). In this case, to reduce the difference in potential in the composite film 4 resulting from the distance from the electrode 53, the composite film 4 preferably has a high conductivity C1 at least for the film surface direction (x direction) perpendicular to the direction in which the electrode extends.

In the aspect shown in FIG. 11, when observed from the z direction perpendicular to the film surface of the composite film 4, an area S1 of a region in which the electrode 53 and the composite film 4 overlap each other is less than 1/2, that is, less than 50% of an area S2 of the composite film 4. The proportion of the area S1 to the area S2 may be, for example, 30% or less, even 20% or less, and in some cases 10% or less.

However, the shape and arrangement of the electrodes in the device are not limited to the examples in FIGS. 10 and 11.

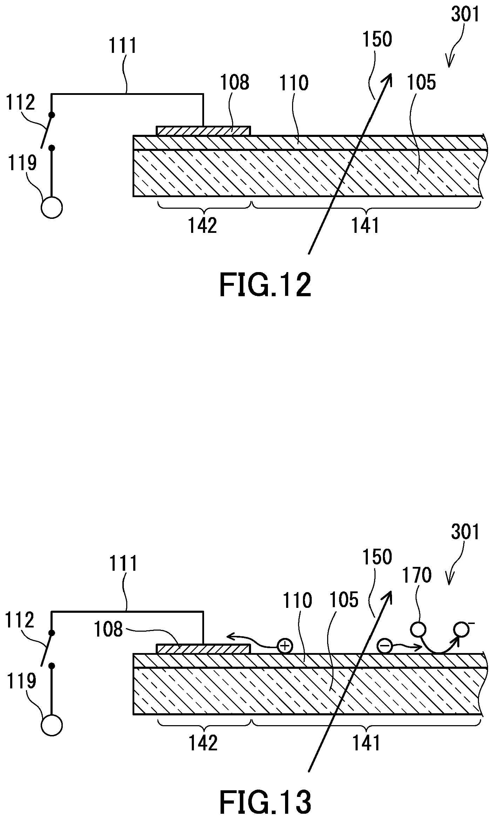

The composite film of the present embodiment is also suitable for use in a heat blocking device. In one example of the device shown in FIG. 12, a heat blocking device 301 includes a base 105 and a composite film (hereinafter also referred to as a "heat blocking film" 110 in the description of the heat blocking device) formed on the base 105. One of the principal surfaces of the heat blocking film 110 is an exposed surface and is in contact with a gas in the outside. The heat blocking film 110 includes: semiconductor nanoparticles that absorb an incident infrared ray to generate electrons and holes (the semiconductor nanoparticles are hereinafter also referred to as "infrared-absorbing particles" in the description of the heat blocking device); and DLC that can accept charge carriers selected from the electrons and the holes from the infrared-absorbing particles. DLC can function as an acceptor for charge carriers to enhance the heat shielding function of the composite film. The composite film may further include an acceptor, other than DLC, that can accept charge carriers selected from electrons and holes from the infrared-absorbing particles. The heat blocking device 301 includes an electrode 108 disposed in contact with a portion of the heat blocking film 110. The electrode 108 is formed on a peripheral portion of the surface of the heat blocking film 110. The electrode 108 is a metal film, for example, and is substantially non-light-transmissive, but it may be a light-transmissive film. One end of a conductive portion 111 is connected to the electrode 108. The other end of the conductive portion 111 is connected to a release destination 119 for charge carriers. The release destination 119 is a charge receiving portion present in the outside of the device. The conductive portion 111 has a switching element 112 between the electrode 108 and the release destination 119.

An example of the release of charge carriers in the embodiment in FIG. 12 will be described with reference to FIG. 13. In this example, electrons generated in the heat blocking film 110 reduce a chemical species 170 in the outside on the principal surface of the heat blocking film 110 and consequently are released from the heat blocking device 301. In this example, the heat blocking film 110 functions as a photocatalyst and accelerates the reaction of the chemical species 170. In contrast, holes pass through the electrode 108 and the conductive portion 111 and are led out to the release destination 119. Note that the release of charge carriers shown in FIG. 13 is only one example of various embodiments of the release. The release of charge carriers may proceed by a chemical reaction involving the oxidation and reduction of the chemical species in the outside by the charge carriers, the leading-out of the charge carriers to the outside, or a combination of these. The reaction such as oxidation of the chemical species in the outside may involve decomposition and/or modification of the chemical species.

The heat blocking device 301 has a light-receiving region that can receive incident light 150 including an infrared ray. The light-receiving region includes a light-transmissive region 141 through which at least a portion of visible light included in the incident light 150 passes and a non-light-transmissive region 142 through which the visible light included in the incident light 150 does not substantially pass.

Note that in photoelectric conversion devices, two principal surfaces of a power generation layer (photoelectric conversion layer) are entirely coated with adjacent layers and are not exposed to the outside, unlike those of the heat blocking film 110 in the heat blocking device 301. In addition, in photoelectric conversion devices, charges are supplied to a circuit including at least one of an inverter, an electricity storage device, a voltmeter, and an ammeter, unlike those in FIGS. 12 and 13.

The heat blocking device 301 includes the heat blocking film 110 that is an infrared-absorbing film and may be connected to the outside of the device so that at least one selected from the group consisting of a) to c) below is satisfied:

a) at least a portion of charge carriers selected from electrons and holes generated in the composite film (infrared-absorbing film) by infrared irradiation are released by oxidizing or reducing a chemical species in the outside of the device, the outside being in contact with a principal surface of the infrared-absorbing film and being in a gaseous phase or a liquid phase;

b) at least a portion of electrons and holes generated in the composite film (infrared-absorbing film) by infrared irradiation are recombined in the outside of the device, the outside being other than a circuit including at least one of an inverter, an electricity storage device, a voltmeter, and an ammeter; and

c) at least a portion of charge carriers selected from electrons and holes generated in the composite film (infrared-absorbing film) by infrared irradiation are released to the outside of the device, the outside having a ground potential.

While the above description uses, as examples of a device including the composite film of the present embodiment, the device utilizing the light transmittance of the film and the heat blocking device, the device including the composite film of the present embodiment is not limited to these. In particular, in each of the devices described as examples, the conductive portion, such as an electrode, is electrically connected to the composite film. However, a device utilizing the composite film does not require a conductive portion depending on the type of device.

<Method for Manufacturing Semiconductor Nanoparticle Composite Film>

A manufacturing method of the present embodiment is a manufacturing method including: a first step of forming a semiconductor nanoparticle-containing film including semiconductor nanoparticles and a carbon source; and a second step of irradiating the semiconductor nanoparticle-containing film with an ion beam to generate DLC, thereby obtaining a semiconductor nanoparticle composite film including the semiconductor nanoparticles and the DLC, wherein the carbon source includes an organic compound other than a polymer. The semiconductor nanoparticle-containing film may be free of a polymer. The carbon source may be an organic compound included in the binder described above. The carbon source may include an adhered compound adhering to the semiconductor nanoparticles. The carbon source may consist of a low molecular weight compound.

The first step may be, for example, a step of forming a semiconductor nanoparticle-containing film including semiconductor nanoparticles and a binder. This step is only required to be performed in accordance with the description in Patent Literature 1. However, the first step is not limited to the contents described in Patent Literature 1. For example, the semiconductor nanoparticle-containing film does not need to satisfy that at least a portion of the semiconductor nanoparticles are arranged in line.

The DLC to be generated in the second step may include carbon atoms derived from the carbon source included in the semiconductor nanoparticle-containing film. However, the DLC may also include carbon atoms derived from another carbon source, for example, a carbon source supplied from the substrate. Any ion beam type, dose amount, etc. that can generate DLC in the film may be used. The ionic species constituting the ion beam is not particularly limited and is, for example, helium, argon, nitrogen, or carbon. The composite film can include, for example, an inert element and/or nitrogen depending on the ion beam used for irradiation.

The second step may involve modification of the semiconductor nanoparticles together with the generation of DLC. The modification may be, for example, transformation of the semiconductor material included in the semiconductor nanoparticles and may be an increase in the carrier density of the semiconductor material. The transformation of the semiconductor material may be, for example, generation of a p-type semiconductor material from an intrinsic semiconductor.

It is possible to form the composite film of the present invention by, in addition to the above method, vapor-phase synthesis such as plasma CVD to generate DLC in a film in which semiconductor nanoparticles are formed.

The present invention will be further described below with reference to examples. The following description is not intended to limit the present invention to any particular example, either.

(Example 1)

(Formation of Semiconductor Nanoparticle-Containing Film)

Copper sulfide nanoparticles were synthesized according to an existing method (Chemistry of Materials, 2017, 29, 4783-4791). The copper sulfide nanoparticle ink thus synthesized was dispersed in octane. The resulting ink was defined as a first ink. The copper sulfide nanoparticles included in the first ink were disc-shaped and had an average maximum particle diameter of 30 nm.

Onto a polyethylene terephthalate (PET) substrate, 50 $\mu$l of the first ink was applied with a spin coater to obtain a coating film. In the application, the first ink was adjusted to a concentration of 50 mg/ml.

Onto the coating film, 200 $\mu$l of a solution (second ink) including hydrazine ($H_2NNH_2$) was applied with a spin coater to obtain a thin film that would function as a heat blocking film. The solvent for the solution was octane, and hydrazine ($H_2NNH_2$) was adjusted to a concentration of 0.3 mass%. The compound coordinated to the copper sulfide nanoparticles was brought into contact with the second ink, and accordingly, in a portion of the compound, oleylamine (first compound) was substituted with hydrazine ($H_2NNH_2$) (second compound).

On the coating film, an additional coating film was formed by the same film formation as above using the first ink. Then, compound substitution was performed by using the second ink in the same manner as above. Thus, a PET substrate was obtained on which a semiconductor nanoparticle-containing film having an increased film thickness was formed.

(Ion Beam Irradiation)

Subsequently, the PET substrate having the semiconductor nanoparticle-containing film formed thereon was irradiated with an ion beam under the following conditions. Thus, semiconductor nanoparticle composite films were obtained.

- Ionic species: Helium
- Dose amount: Beam current value: 0.5 nA/mm$^2$/s
- Beam flux: $3.12 \times 10^9$ ion/mm$^2$/s
- Irradiation duration: 5 minutes, 10 minutes, 20 minutes, and 40 minutes

The semiconductor nanoparticle composite films obtained had a film thickness of 100 nm.

(Analysis by XRD and FT-IR)

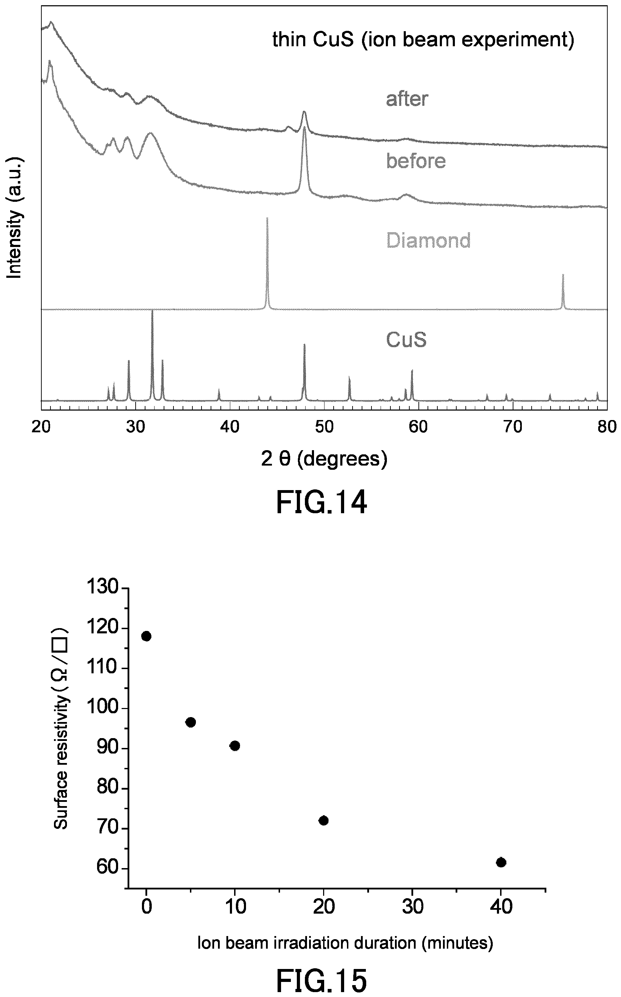

FIG. 14 shows an example of the results of X-ray diffraction (XRD) analysis on the semiconductor nanoparticle composite films. The results show a peak attributed to a diamond structure. The semiconductor nanoparticle composite films were also measured by Fourier transform infrared spectroscopy (FT-IR), and the results show a peak attributed to an sp$^3$ carbon structure near 2900 cm$^{-1}$ and a peak attributed to an sp$^2$ carbon structure near 1600 cm$^{-1}$.

(Measurement of Hardness and Elastic Modulus)

Measurement of hardness and elastic modulus by nanoindentation was performed on the semiconductor nanoparticle-containing film (ion beam irradiation duration: 0 minutes) and the semiconductor nanoparticle composite film (ion beam irradiation duration: 40 minutes). The results are shown in the following table.

[Table 1]

|  | Maximum indentation depth (nm) | Hardness (N/mm$^2$) | Elastic modulus (N/mm$^2$) |
|---|---|---|---|
| Semiconductor nanoparticle composite film (With beam irradiation) | 12.01 | 1912 | 18900 |
| Semiconductor nanoparticle-containing film (Without beam irradiation) | 25.24 | 711.3 | 6695 |
| PET substrate | 22.44 | 972.9 | 6538 |

The above analysis and measurement demonstrate that ion beam irradiation generated DLC in the film and cured the film. At least a portion of the carbon atoms constituting the DLC are presumably derived from oleylamine that remained in the film even after the substitution with hydrazine.

(Measurement of Surface Resistivity)

Measurement of surface resistivity by a four-point probe method was performed on the semiconductor nanoparticle-containing film (ion beam irradiation duration: 0 minutes) and the semiconductor nanoparticle composite films (ion beam irradiation duration: 5 minutes, 10 minutes, 20 minutes, and 40 minutes). The results are shown in FIG. 15. The results demonstrate that the surface resistivity significantly decreases depending on the ion beam irradiation amount. The ion beam irradiation decreased the surface resistivity to about 50%. Referring to the results of cross-sectional observation with an electron microscope, the significant improvement in the conductivity of the film, which resulted in the decrease in surface resistivity, is presumably not due to the reduction in spacing between the semiconductor nanoparticles but due to the influence of the DLC generated in the film. Taking into account the film thickness of the composite film (100 nm), a surface resistivity of 100 Ω/□ corresponds to 1000 S/cm. The semiconductor nanoparticle composite film according to the present example has a conductivity corresponding to a surface resistivity of less than 100 Ω/□, that is, a conductivity of more than 1000 S/cm.

(Flexural Test)

A flexural test was performed on the PET substrate having the semiconductor nanoparticle-containing film (ion beam irradiation duration: 0 minutes) formed thereon and the PET substrate having the semiconductor nanoparticle composite films (ion beam irradiation duration: 5 minutes, 20 minutes, and 40 minutes) formed thereon. The details of the flexural test are as described above with reference to FIG. 7. The surface resistivity R2 of each of the films was measured after the test and was substituted into the following formula together with the surface resistivity R1 measured before the test to calculate the rate of change in resistance:

$$(R2 - R1)/R1 \times 100 \ [\%]$$

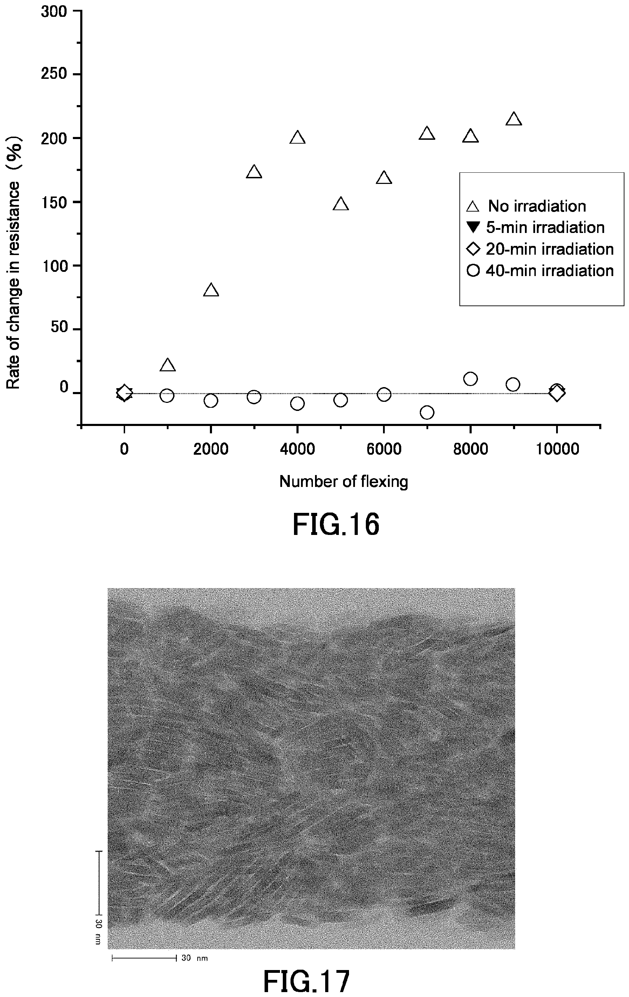

The results are shown in FIG. 16.

For the composite films with irradiation durations of 5 minutes and 20 minutes, R2 was measured only after 10000 cycles (10000 times) of flexing. The results are shown in FIG. 16. The composite films each had a rate of change in resistance of 20% or less up to 10000 cycles. In contrast, the film without ion beam irradiation had a rate of change in resistance exceeding 70% after 2000-time flexing in the flexural test. Due to time constraints, the number of cycles in the flexural test was terminated after reaching 10000 times, during which no substantial change was observed in the surface resistivity of each of the composite films. The improvement in the folding resistance by the composition with DLC was more than expected.

(Infrared Light Irradiation Test)

The PET substrate having the semiconductor nanoparticle-containing film (ion beam irradiation duration: 0 minutes) formed thereon and the PET substrate having the semiconductor nanoparticle composite film (ion beam irradiation duration: 30 minutes) formed thereon were irradiated with infrared light and the temperature rise was measured. The substrates with the films were irradiated with light from an AM 1.5 simulated sunlight source (100 mW), which had passed through a bandpass filter so as to include only light having a wavelength of 600 nm or more. In 10 minutes from the start of the irradiation, the semiconductor nanoparticle-containing film rose in temperature by 2.7°C. In contrast, the semiconductor nanoparticle composite film rose in temperature by 1.8°C.

(Light Transmission Test)

Transmittance measurement for visible light and infrared light was performed on the semiconductor nanoparticle composite film (ion beam irradiation duration: 10 minutes) with a spectrophotometer, Shimadzu UV3600. The light transmittance at a wavelength of 560 nm was 84%. In the visible region, high transmittance was observed, which slightly decreased from the 94% transmittance before the ion beam irradiation. This is because helium, which is highly permeable, was used as the ionic species of the ion beam and consequently reacted with the PET material of the substrate, causing discoloration. In the infrared region, in contrast, the transmittance was sufficiently low, with a transmittance of less than 40% at a wavelength of 1000 nm to 2500 nm.

(Peel Test)

The films were subjected to a peel test by a pull-off method using an adhesive tape. The adhesive tape used was Cellotape (registered trademark) CT1835-5P manufactured by Nichiban Co., Ltd. The adhesive tape was applied to each of the semiconductor nanoparticle composite films (ion beam irradiation duration: 5 to 40 minutes) formed on the PET substrate, and then peeled off. No delamination was observed for any of the films.

(Example 2)

In the same manner as in Example 1, an ink was obtained that included disc-shaped copper sulfide nanoparticles having an average height of 5 nm and an average diameter (average maximum particle diameter) of 30 nm. In the same manner as in Example 1 except for the use of the above ink instead of the first ink, application onto a PET substrate and a glass substrate was performed to obtain semiconductor nanoparticle-containing films. However, the film thicknesses were increased compared to that in Example 1. The semiconductor nanoparticle-containing film on the glass substrate had a surface resistivity of 41 $\Omega/\square$, and the semiconductor nanoparticle-containing film on the PET substrate had a surface resistivity of 70 $\Omega/\square$.

A plurality of inks were produced in the same manner. According to the results of an examination of the relationship between the average maximum particle diameter of the semiconductor nanoparticles and the surface resistivity of the film, it is demonstrated that the influence of the average maximum particle diameter on the surface resistivity is prominent for the PET substrate. In particular, for the PET substrate, when the average maximum particle diameter fell below about 20 nm, the surface resistivity increased significantly and sometimes exceeded 100 times the above surface resistivity. This tendency persists even after ion beam irradiation. The average maximum particle diameter of the semiconductor nanoparticles is not limited to 20 nm or more. However, for a substrate having hydrophobic surfaces, such as a PET substrate, the use of relatively large semiconductor nanoparticles is presumably desirable.

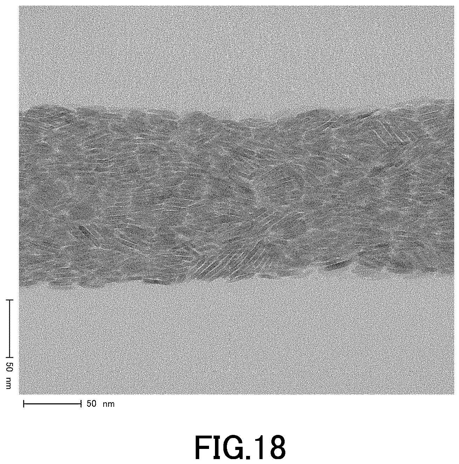

FIGS. 17 and 18 show TEM images of semiconductor nanoparticle composite films obtained in the same manner as in Examples 1 and 2. On the observation surfaces, the proportion of the semiconductor nanoparticles exceeded 50%. It is also demonstrated that a portion of the semiconductor nanoparticles are arranged in line with a slight distance kept therebetween.

(Example 3)

A PET substrate having a semiconductor nanoparticle-containing film formed thereon was obtained in the same manner as in Example 2. The semiconductor nanoparticle-containing film formed had a surface resistivity of 243 $\Omega/\square$.

Subsequently, the PET substrate having the semiconductor nanoparticle-containing film formed thereon was irradiated with an ion beam under the conditions shown in Table 2. The surface resistivities after the ion beam irradiation are also shown in Table 2.

[Table 2]

| Implantation amount | Ionic species | Implantation energy keV | Implantation amount $\times 10^{12}$ atoms/cm$^2$ | Beam current $\mu$A | Implantation duration sec | Surface resistivity $\Omega/\square$ |
|---|---|---|---|---|---|---|
| Without irradiation | - | - | - | - | - | 243.0 |
| 1 | N | 100 | 3.74 | 0.39 | 26.3 | 230.0 |
| 2 | N | 100 | 7.49 | 0.77 | 27.5 | 219.0 |
| 3 | N | 100 | 74.9 | 1.53 | 133.4 | 189.7 |
| 4 | N | 100 | 749 | 1.51 | 1346 | 148.2 |

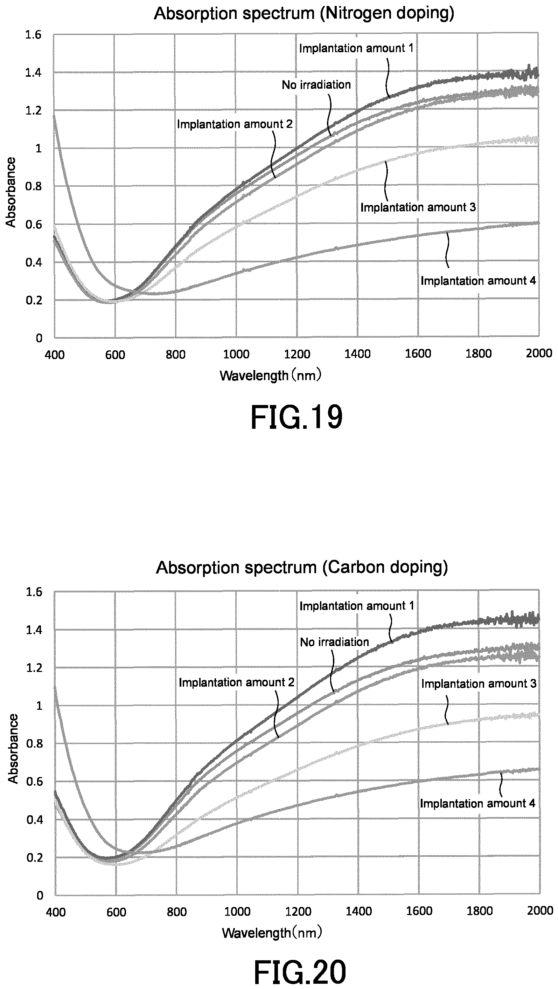

The PET substrate having the semiconductor nanoparticle composite films formed thereon was further measured for absorbance with a spectrophotometer. The results are shown in FIG. 19.

(Example 4)

A PET substrate having a semiconductor nanoparticle-containing film formed thereon was obtained in the same manner as in Example 3. Subsequently, the PET substrate having the semiconductor nanoparticle-containing film formed thereon was irradiated with an ion beam under the conditions shown in Table 3. The surface resistivities after the ion beam irradiation are also shown in Table 3.

[Table 3]

| Implantation amount | Ionic species | Implantation energy keV | Implantation amount $\times 10^{12}$ atoms/cm$^2$ | Beam current $\mu$A | Implantation duration sec | Surface resistivity $\Omega/\square$ |
|---|---|---|---|---|---|---|
| Without irradiation | - | - | - | - | - | 243.0 |
| 1 | C | 100 | 3.74 | 0.37 | 27.6 | 215.5 |
| 2 | C | 100 | 7.49 | 0.75 | 27.6 | 293.5 |

(continued)

| Implantation amount | Ionic species | Implantation energy keV | Implantation amount $\times 10^{12}$ atoms/cm$^2$ | Beam current μA | Implantation duration sec | Surface resistivity Ω/□ |
|---|---|---|---|---|---|---|
| 3 | C | 100 | 74.9 | 1.13 | 180 | 208.0 |
| 4 | C | 100 | 749 | 1.01 | 2020 | 144.8 |

The PET substrate having the semiconductor nanoparticle composite films formed thereon was further measured for absorbance with a spectrophotometer. The results are shown in FIG. 20.

(Example 5)

A PET substrate having a semiconductor nanoparticle-containing film formed thereon was obtained in the same manner as in Example 2. The semiconductor nanoparticle-containing film formed had a surface resistivity of 134.9 Ω/□.
Subsequently, the PET substrate having the semiconductor nanoparticle-containing film formed thereon was irradiated with an ion beam under the conditions shown in Table 4. The surface resistivities after the ion beam irradiation are also shown in Table 4.

[Table 4]

| Implantation amount | Ionic species | Implantation energy keV | Implantation amount $\times 10^{12}$ atoms/cm$^2$ | Beam current μA | Implantation duration sec | Surface resistivity Ω/□ |
|---|---|---|---|---|---|---|
| Without irradiation | - | - | - | - | - | 134.9 |
| 1 | Ar | 100 | 3.74 | 0.38 | 27.1 | 135.1 |
| 2 | Ar | 100 | 7.49 | 0.75 | 27.5 | 123.7 |
| 3 | Ar | 100 | 74.9 | 1.51 | 134.9 | 124.9 |
| 4 | Ar | 100 | 749 | 1.51 | 1345 | 181.2 |

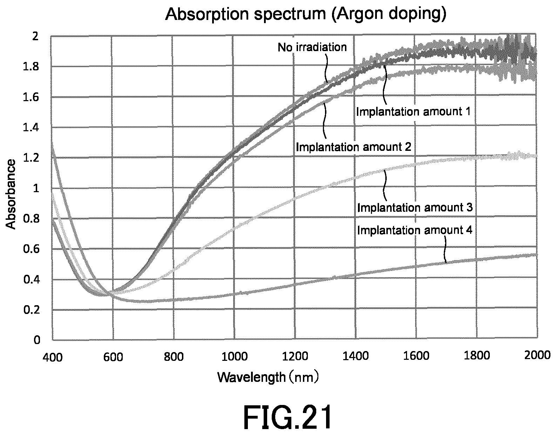

The PET substrate having the semiconductor nanoparticle composite films formed thereon was further measured for absorbance with a spectrophotometer. The results are shown in FIG. 21. The Ar ion beam irradiation exhibited less coloration than the N and C ion beam irradiation, finding out that the conductivity can be improved by an appropriate adjustment of the implantation amount while sufficient visible transmittance is ensured. It was also demonstrated that the Ar ion beam irradiation prominently improves the film durability.
Tables 2 to 4 and FIGS. 19 to 21 demonstrate that the properties of the semiconductor nanoparticle composite films can be adjusted by selecting the ionic species and controlling the ion beam irradiation amount.

(Example 6)

A thin-film organic solar cell was produced that included a semiconductor nanoparticle composite film as the conductive layer. First, a CuS film composed of 30 to 60 layers each having a film thickness of 200 to 400 nm was formed by spin coating on a PET substrate subjected to UV ozone treatment. Next, helium or carbon ion beam irradiation was performed under the conditions shown in Table 5 to generate DLC. Furthermore, the film surface was subjected to UV ozone treatment. PEDOT·PSS was then applied by spin coating (2000 rpm, 45 seconds), and a baking process was performed with a hot plate at 120°C for 15 minutes. The PEDOT PSS layer serving as the hole transport layer had a thickness of about 30 nm.
Subsequently, a power generation layer was formed. First, 20 mg of poly(3-hexylthiophene-2,5-diyl) (hereinafter referred to as "P3HT") and 20 mg of (6,6)-phenyl C61-butyric acid methyl ester (hereinafter referred to as "PCBM") were added to 1,2-dichlorobenzene, followed by ultrasonic processing for 30 minutes to completely dissolve P3HT and PCBM in 1,2-dichlorobenzene. Thus, a power generation layer formation liquid was completed. The power generation layer formation liquid was applied onto the hole transport layer by spin coating (800 rpm, 30 seconds). The coating liquid was left in a glass petri dish for 1 hour during which the 1,2-dichlorobenzene was gradually evaporated to form a power generation layer having a thickness of about 100 nm.
Furthermore, an electron transport layer was formed. First, a ZnO nanoparticle layer formation liquid was produced by the method described in Wilken, S.; Parisi, J.; Borchert, H. Role of Oxygen Adsorption in Nanocrystalline ZnO Interfacial Layers for Polymer-Fullerene Bulk Heterojunction Solar Cells. J. Phys. Chem. C 2014, 118, 19672-19682. The formation liquid was applied onto the power generation layer by spin coating (2000 rpm, 30 seconds). The ZnO nanoparticle layer had a thickness of about 140 nm. Lastly, a Ag electrode having a thickness of 100 nm was formed on the electron transport layer with a resistance heating evaporation system.

The characteristics of the thin-film solar cell thus obtained are shown in Table 6. The characteristics of the thin-film solar cell were measured with OTENTO-SUN VI-OP High Proximity Solar Simulator manufactured by Bunkoukeiki Co., Ltd as the light source and Keithley Model 2400 as the source meter.

[Table 5]

| Ionic species | Implantation energy keV | Implantation amount $\times 10^{13}$ atoms/cm$^2$ | Beam current $\mu$A | Implantation duration sec |
|---|---|---|---|---|
| He | 100 | 80.1 | 1.27 | 1726.3 |
| C | 100 | 7.49 | 1.13 | 180 |

[Table 6]

| Hole transport layer Ionic species | Isc mA | Voc V | FF | Pmax $\mu$W | Jsc mA/cm$^2$ | $\eta$ % |
|---|---|---|---|---|---|---|
| He | 0.088 | 0.241 | 0.311 | 6.584 | 1.786 | 0.134 |
| C | 0.051 | 0.106 | 0.265 | 1.447 | 1.047 | 0.029 |

## Claims

1. A semiconductor nanoparticle composite film comprising semiconductor nanoparticles and diamond-like carbon, the composite film satisfying at least one selected from the group consisting of:

   i) the composite film comprises mainly the semiconductor nanoparticles; and
   ii) at least a portion of the semiconductor nanoparticles are arranged in line.

2. The semiconductor nanoparticle composite film according to claim 1, wherein the semiconductor nanoparticles comprise a semiconductor material other than titanium oxide.

3. The semiconductor nanoparticle composite film according to claim 1, satisfying at least the i).

4. The semiconductor nanoparticle composite film according to any one of claims 1 to 3, further satisfying at least one selected from the group consisting of:

   iii) the semiconductor nanoparticles comprise a p-type semiconductor material;
   iv) the semiconductor nanoparticles comprise an impurity semiconductor material;
   v) the semiconductor nanoparticles comprise an LSPR-IR absorbing semiconductor material; and
   vi) the composite film further comprises an acceptor material that accepts electrons or holes, generated in the semiconductor nanoparticles by infrared irradiation, from the semiconductor nanoparticles.

5. The semiconductor nanoparticle composite film according to claim 4, satisfying at least the iii).

6. The semiconductor nanoparticle composite film according to any one of claims 1 to 5, wherein in the composite film, electrons or holes, generated in the semiconductor nanoparticles by infrared irradiation, at least partly move to the diamond-like carbon.

7. The semiconductor nanoparticle composite film according to any one of claims 1 to 6, having a surface resistivity of 1000 $\Omega/\square$ or less.

8. The semiconductor nanoparticle composite film according to claim 7, having a surface resistivity of 100 $\Omega/\square$ or less.

9. The semiconductor nanoparticle composite film according to any one of claims 1 to 8, having a conductivity of 500 S/cm or more.

10. The semiconductor nanoparticle composite film according to any one of claims 1 to 9, having a resistance change rate of 50% or less calculated by the following formula:

$$(R2 - R1)/R1 \times 100 \ [\%]$$

where R1 is a surface resistivity before a flexural test in which flexing is applied 2000 times, and R2 is a surface resistivity after the flexural test.

11. The semiconductor nanoparticle composite film according to any one of claims 1 to 10, wherein the semiconductor nanoparticles have an average maximum diameter of 1 nm to 2000 nm.

12. A composite base comprising:

a substrate; and
the semiconductor nanoparticle composite film according to any one of claims 1 to 11.

13. The composite base according to claim 12, wherein the substrate is a resin substrate.

14. A device comprising:

the semiconductor nanoparticle composite film according to any one of claims 1 to 11; and
a conductive portion electrically connected to the semiconductor nanoparticle composite film.

15. The device according to claim 14, being at least one selected from the group consisting of a photovoltaic device, an image display device, a heat generating device, and an electromagnetic shielding device.

16. A method for manufacturing the semiconductor nanoparticle composite film according to any one of claims 1 to 11, the method comprising:

forming a semiconductor nanoparticle-containing film comprising semiconductor nanoparticles and a carbon source; and
irradiating the semiconductor nanoparticle-containing film with an ion beam to generate diamond-like carbon, thereby obtaining a semiconductor nanoparticle composite film comprising the semiconductor nanoparticles and the diamond-like carbon, wherein
the carbon source comprises an organic compound other than a polymer.

17. The method according to claim 16, wherein the semiconductor nanoparticle-containing film is free of a polymer.

FIG.1

FIG.2

FIG.3

FIG.4

FIG.5

FIG.6

FIG.7

FIG.8

FIG.9

FIG.10

FIG.11

FIG.12

FIG.13

FIG.14

FIG.15

FIG.16

FIG.17

FIG.18

FIG.19

FIG.20

Absorption spectrum (Argon doping)

FIG.21

## INTERNATIONAL SEARCH REPORT

| International application No. |
|---|
| **PCT/JP2023/003128** |

**A. CLASSIFICATION OF SUBJECT MATTER**

*C01G 3/12*(2006.01)i; *B82Y 20/00*(2011.01)i; *B82Y 25/00*(2011.01)i; *B82Y 30/00*(2011.01)i; *B82Y 40/00*(2011.01)i; *C01B 32/05*(2017.01)i

FI: C01B32/05; B82Y20/00; B82Y25/00; B82Y30/00; B82Y40/00; C01G3/12

According to International Patent Classification (IPC) or to both national classification and IPC

**B. FIELDS SEARCHED**

Minimum documentation searched (classification system followed by classification symbols)

C01G3/12; B82Y20/00; B82Y25/00; B82Y30/00; B82Y40/00; C01B32/05

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

JSTPlus/JMEDPlus/JST7580 (JDreamIII); JSTChina (JDreamIII)

**C. DOCUMENTS CONSIDERED TO BE RELEVANT**

| Category* | Citation of document, with indication, where appropriate, of the relevant passages | Relevant to claim No. |
|---|---|---|
| X | JIANG et al. Enhanced field emission properties from graphene-TiO2/DLC nanocomposite films prepared by ultraviolet-light assisted electrochemical deposition. Journal of Alloys and Compounds. 25 November 2016, vol. 686, pages 588-592, doi:10.1016/j.jallcom.2016.06.084 abstract, 2.-3. | 1, 3-4, 6-12, 14-15 |
| X | MARCIANO et al. Antibacterial activity of DLC films containing TiO2 nanoparticles. Journal of Colloid and Interface Science. 01 December 2009, vol. 340, no. 1, pages 87-92, doi:10.1016/j.jcis.2009.08.024 abstract, 2.-3. | 1, 3-4, 6-12 |
| Y | WO 2021/075495 A1 (KYOTO UNIV.) 22 April 2021 (2021-04-22) claims 1-22, paragraphs [0001]-[0118], fig. 1-11 | 1-17 |
| Y | WO 2014/175432 A1 (NAGAMACHI SCIENCE LABORATORY CO., LTD.) 30 October 2014 (2014-10-30) claims 1-9, paragraphs [0001]-[0050] | 1-17 |

☐ Further documents are listed in the continuation of Box C. ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **28 March 2023** | **18 April 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/003128**

| Patent document cited in search report | | | Publication date (day/month/year) | Patent family member(s) | | | Publication date (day/month/year) |
|---|---|---|---|---|---|---|---|
| WO | 2021/075495 | A1 | 22 April 2021 | EP | 4047061 | A1 | |
| | | | | claims 1-22, paragraphs [0001]-[0119], fig. 1-11 | | | |
| | | | | CN | 114651312 | A | |
| | | | | KR | 10-2022-0087478 | A | |
| WO | 2014/175432 | A1 | 30 October 2014 | (Family: none) | | | |

Form PCT/ISA/210 (patent family annex) (January 2015)

35

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 202175495 A

- WO 2014175432 A

**Non-patent literature cited in the description**

- *Chemistry of Materials*, 2017, vol. 29, 4783-4791

- **WILKEN, S ; PARISI, J. ; BORCHERT, H.** Role of Oxygen Adsorption in Nanocrystalline ZnO Interfacial Layers for Polymer-Fullerene Bulk Heterojunction Solar Cells.. *J. Phys. Chem. C*, 2014, vol. 118, 19672-19682